(19)

Europäisches Patentamt
European Patent Office
Office européen des brevets

(11)  EP 4 187 604 A1

(12)  EUROPEAN PATENT APPLICATION
published in accordance with Art. 153(4) EPC

(43) Date of publication:
**31.05.2023  Bulletin 2023/22**

(21) Application number: **21879992.2**

(22) Date of filing: **08.10.2021**

(51) International Patent Classification (IPC):
*H01L 27/04* (2006.01)      *H01G 4/30* (2006.01)
*H01G 4/33* (2006.01)       *H01G 4/40* (2006.01)
*H01L 21/822* (2006.01)     *H01L 21/8234* (2006.01)
*H01L 27/06* (2006.01)      *H03H 5/12* (2006.01)

(52) Cooperative Patent Classification (CPC):
**H01G 4/30; H01G 4/33; H01G 4/40; H01L 21/822;
H01L 21/8234; H01L 27/04; H01L 27/06;
H03H 5/12**

(86) International application number:
**PCT/JP2021/037331**

(87) International publication number:
**WO 2022/080253 (21.04.2022 Gazette 2022/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **12.10.2020  JP 2020172070**

(71) Applicants:
• **Murata Manufacturing Co., Ltd.
Nagaokakyo-shi, Kyoto 617-8555 (JP)**
• **Japan Advanced Institute of Science and
Technology
Ishikawa 923-1292 (JP)**

(72) Inventors:
• **MIYASAKO, Takaaki
Nagaokakyo-shi, Kyoto 617-8555 (JP)**
• **TOKUMITSU, Eisuke
Nomi-shi, Ishikawa 923-1292 (JP)**

(74) Representative: **von Tietzen und Hennig, Nikolaus
Lorenz Seidler Gossel
Rechtsanwälte Patentanwälte
Partnerschaft mbB
Widenmayerstraße 23
80538 München (DE)**

(54)    **VARIABLE ELECTRONIC ELEMENT AND CIRCUIT DEVICE**

(57)    A variable capacitive element (100) includes a switch portion (10) configuring a field effect transistor, and an element portion (20) that is electrically connected to the switch portion (10) to configure a capacitor (passive element). The element portion (20) includes a terminal electrode (Sa) (first terminal electrode) electrically connected to the source electrode (5), and a terminal electrode (22) (second terminal electrode) that configures a first capacitor (first passive element) with the source electrode (5) and configures a second capacitor (second passive element) at least with the drain electrode (6).

FIG.1

EP 4 187 604 A1

**Description**

TECHNICAL FIELD

The present invention relates to a variable electronic element that varies a physical quantity of a passive element, and a circuit device including the variable electronic element.

BACKGROUND ART

In recent years, a variable capacitive element capable of varying capacitance (capacitor) has been developed. As a method for varying the capacitance, PTL 1 discloses a variable capacitive element in which a plate-shaped movable interdigital electrode and a plate-shaped fixed interdigital electrode opposite to the movable interdigital electrode with a minute gap interposed therebetween are provided using a micromachining technique.

In addition, as the method for varying the capacitance, NPL 1 discloses a variable capacitive element having a two-terminal structure using an on and off operation of a field effect transistor (FET). In the variable capacitive element, when a voltage is applied to the gate electrode in an on state, electrons in a channel region are accumulated at an interface by + polarization of a gate insulating film (dielectric) and function as an electrode, so that an electrode area on a source electrode side expands to the same area as the gate electrode. Accordingly, capacitance generated between the source electrode and the gate electrode increases.

CITATION LIST

PATENT LITERATURE

PTL 1: Japanese Patent Laying-Open No. 2002-373829

NON PATENT LITERATURE

NPL 1: Tokumitsu Eisuke, Kikuchi Kazuya, "Evaluation of Channel Modulation in In2O3/(Bi,La)4Ti3O12 Ferroelectric-Gate Thin Film Transistors by Capacitance-Voltage Measurements", Ferroelectrics, 429, p.15-21, Jun 2012

SUMMARY OF INVENTION

TECHNICAL PROBLEM

However, in the variable capacitive element disclosed in PTL 1, the variable capacitance has a width as small as about several times the variable capacitance before the variable, and the variable capacitance has an insufficient width for use in applications such as a wide-band communication system and a power supply circuit that are required to significantly modulate a frequency.

In addition, in the variable capacitive element disclosed in NPL 1, when a film thickness of the gate insulating film (dielectric) is increased in order to increase a withstand voltage, a capacitance value decreases in inverse proportion to the film thickness. Furthermore, in the variable capacitive element disclosed in NPL 1, when the film thickness of the gate insulating film (dielectric) is increased, a control voltage applied to the gate electrode increases in proportion to the film thickness, so that power consumption increases.

Therefore, an object of the present invention is to provide a variable electronic element and a circuit device capable of widening a range in which the physical quantity (for example, variable capacitance) of the passive element can be varied and obtaining a sufficient withstand voltage without reducing the physical quantity of the passive element.

SOLUTION TO PROBLEM

A variable electronic element according to an aspect of the present disclosure includes: a switch portion that configures a field effect transistor; an element portion that is electrically connected to the switch portion to configure a passive element, in which the switch portion includes: a source electrode; a drain electrode; a channel formation film formed so as to overlap at least a part of the source electrode and a part of the drain electrode; a gate insulating film formed to overlap the channel formation film; and a gate electrode formed so as to overlap the gate insulating film, and the element portion includes: a first terminal electrode electrically connected to the source electrode; and a second terminal electrode that configures a first passive element with the source electrode and configures a second passive element at least with the drain electrode.

A circuit device according to another aspect of the present disclosure includes: a circuit wiring; and the variable electronic element electrically connected to the circuit wiring.

ADVANTAGEOUS EFFECTS OF INVENTION

According to the present disclosure, the first passive element is configured between the source electrode and the second terminal electrode, and the second passive element is configured between the drain electrode and the second terminal electrode, so that a range in which the physical quantity of the passive element can be varied can be widened and a sufficient withstand voltage can be obtained without reducing the physical quantity of the passive element.

BRIEF DESCRIPTION OF DRAWINGS

Fig. 1 is a sectional view illustrating a configuration of a variable capacitive element according to a first embodiment.
Fig. 2 is a plan view illustrating the configuration of the variable capacitive element of the first embodiment.
Fig. 3 is a circuit diagram illustrating the variable capacitive element of the first embodiment.
Fig. 4 is a graph illustrating a width of a variable capacitance of the variable capacitive element according to the first embodiment.
Fig. 5 is a sectional view illustrating a method for manufacturing the variable capacitive element of the first embodiment.
Fig. 6 is a circuit diagram illustrating a multi-valued variable capacitive element of the first embodiment.
Fig. 7 is a sectional view illustrating a configuration of a variable capacitive element according to a modification of the first embodiment.
Fig. 8 is a sectional view illustrating a configuration of a variable inductance element according to a second embodiment.
Fig. 9 is a circuit diagram illustrating the variable inductance element of the second embodiment.
Fig. 10 is a circuit diagram illustrating a circuit device according to a third embodiment.
Fig. 11 is a graph illustrating a frequency characteristic of the circuit device of the third embodiment.
Fig. 12 is a block diagram illustrating a circuit device according to a fourth embodiment.
Fig. 13 is a timing chart illustrating switching timing of the circuit device of the fourth embodiment.
Fig. 14 is a block diagram illustrating a circuit device according to a fifth embodiment.
Fig. 15 is a circuit diagram of a circuit device according to a sixth embodiment.
Fig. 16 is a graph illustrating a switching characteristic of the circuit device of the sixth embodiment.
Fig. 17 is a sectional view illustrating a configuration of a variable capacitive element according to a seventh embodiment.
Fig. 18 is a plan view illustrating the configuration of the variable capacitive element of the seventh embodiment.
Fig. 19 is a sectional view illustrating a configuration of a variable capacitive element according to an eighth embodiment.
Fig. 20 is a plan view illustrating the configuration of the variable capacitive element of the eighth embodiment.
Fig. 21 is a sectional view illustrating a configuration of a variable capacitive element according to a modification of the eighth embodiment.
Fig. 22 is a sectional view illustrating a configuration of a variable capacitive element according to a modification.
Fig. 23 is a view illustrating a relationship between capacitance and a holding voltage of the variable capacitive element.
Fig. 24 is a diagram for explaining the relationship between the capacitance and the retention time of the variable capacitive element.

DESCRIPTION OF EMBODIMENTS

With reference to the drawings, a variable electronic element according to an embodiment of the present invention will be described in detail below. A variable electronic element is an element capable of varying a physical quantity of an included passive element, and the included passive element includes a capacitor, an inductor, a resistor, and the like. In the drawings, the same reference numeral denotes the same or corresponding parts.

(First embodiment)

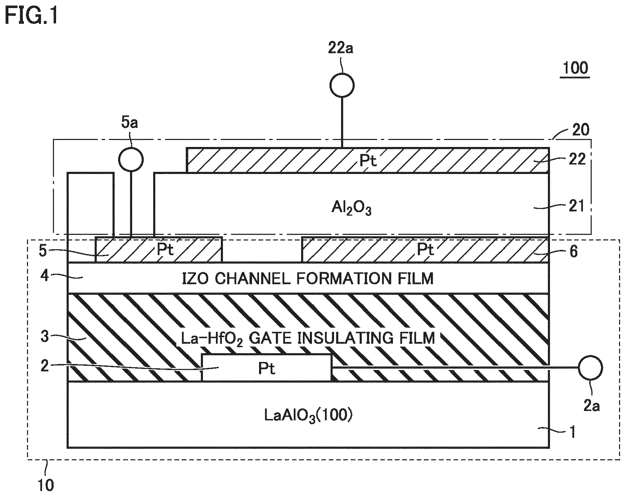

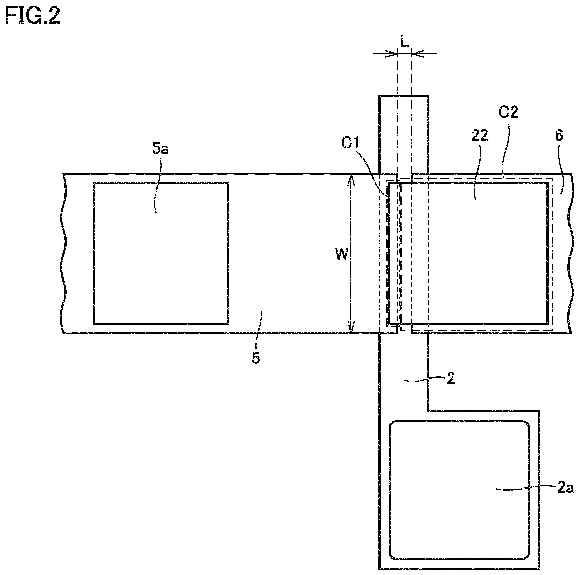

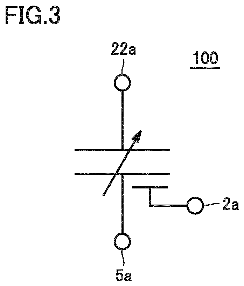

In a first embodiment, a variable capacitive element in which the included passive element is the capacitor and capacitance can be varied will be described with reference to the drawings. Fig. 1 is a sectional view illustrating a configuration of a variable capacitive element 100 according to a first embodiment. Fig. 2 is a plan view illustrating the configuration of variable capacitive element 100 of the first embodiment. Fig. 3 is a circuit diagram illustrating variable capacitive element 100 of the first embodiment.

Variable capacitive element 100 in Fig. 1 includes a switch portion 10 configuring a field effect transistor formed on a semiconductor substrate 1 and an element portion 20 that is electrically connected to switch portion 10 and configures a passive element. Element portion 20 is provided above switch portion 10.

Switch portion 10 includes a gate electrode 2, a gate insulating film 3, a channel formation film 4, a source electrode 5, and a drain electrode 6. In switch portion 10 of Fig. 1, gate electrode 2 is formed on semiconductor substrate 1, gate insulating film 3 and channel formation film 4 are sequentially formed so as to overlap gate electrode 2, and source electrode 5 and drain electrode 6 are respectively formed on gate insulating film 3 and channel formation film 4.

More specifically, switch portion 10 is an oxide field effect transistor (FET). For semiconductor substrate 1, for example, lanthanum aluminate (LAO) is used, and gate electrode 2 is formed of platinum (Pt) on the lanthanum aluminate in a predetermined pattern of Fig. 2. For example, a La-HfO$_2$ film having a film thickness of 70 nm is used for gate insulating film 3, and an IZO film having a film thickness of 25 nm is used for channel formation film 4. Source electrode 5 and drain electrode 6 are formed of platinum (Pt) in the predetermined pattern of Fig. 2 on channel formation film 4 of the IZO film. Although a terminal electrode 5a (first terminal electrode) is provided on source electrode 5 in Fig. 2, source electrode 5 itself may be used as terminal electrode 5a. In switch portion 10, for example, a channel width W is set to 100 μm, and a channel length L is set to 10 μm.

Element portion 20 is provided above switch portion 10 and includes an Al$_2$O$_3$ film of a dielectric 21 and a terminal electrode 22 (second terminal electrode) of platinum (Pt) formed to overlap dielectric 21. Terminal electrode 22 is formed in the predetermined pattern of Fig. 2. As illustrated in Fig. 2, gate electrode 2 is extended from a region where source electrode 5 and drain electrode 6 overlap each other, and a control electrode terminal 2a is provided on gate electrode 2.

Element portion 20 configures a first capacitor (first passive element) between source electrode 5 and terminal electrode 22, and configures a second capacitor (second passive element) at least between drain electrode 6 and terminal electrode 22. As illustrated in Fig. 2, the first capacitor is a portion C1 where source electrode 5 and terminal electrode 22 overlap each other in planar view. The second capacitor is a portion C2 where drain electrode 6 including channel formation film 4 and terminal electrode 22 overlap each other in planar view.

In variable capacitive element 100, when switch portion 10 is in an off state, a gate voltage greater than or equal to a threshold is not applied to gate electrode 2, so that an electron depletion layer exists at a position of channel formation film 4 overlapping gate electrode 2 in planar view and source electrode 5 and drain electrode 6 are not electrically connected. For this reason, because a voltage is applied only between source electrode 5 and the portion of terminal electrode 22 opposite to source electrode 5, variable capacitive element 100 has the capacitance of only the first capacitor.

However, in the variable capacitive element 100, when switch portion 10 is in an on state, the channel is formed by applying the gate voltage greater than or equal to the threshold to gate electrode 2, and source electrode 5 and drain electrode 6 are electrically connected. For this reason, the voltage is applied between source electrode 5 and drain electrode 6 (including channel formation film 4 therebetween) and opposing terminal electrode 22, so that variable capacitive element 100 becomes a combined capacitance of the first capacitor and the second capacitor.

That is, in variable capacitive element 100, switch portion 10 is turned on and off to switch between the case where the first capacitor element is turned on in element portion 20 and the case where the first capacitor and a second capacitor element are turned on in element portion 20, thereby varying the capacitance of the capacitor. Variable capacitive element 100 is a variable capacitive element that is divided into switch portion 10 that operates on and off by the voltage applied to gate electrode 2 (control electrode terminal 2a), terminal electrode 5a (first terminal electrode), and element portion 20 that operates on terminal electrode 22 (second terminal electrode), and operates on three terminals. For this reason, the structure of variable capacitive element 100 is different from that of the variable capacitive element disclosed in NPL 1 in which the capacitance is varied by two terminals of the gate electrode and the source electrode.

In switch portion 10, the film thickness of gate insulating film 3 is desirably reduced from the viewpoint of power consumption, and a withstand voltage decreases by reducing the film thickness, but a driving voltage decreases, so that low-voltage driving can be performed. Accordingly, in variable capacitive element 100, by utilizing the structure in which gate electrode 2 of switch portion 10 and element portion 20 are electrically separated, apart from reducing the film thickness of gate insulating film 3 to achieve the low-voltage driving and the low-withstand voltage, the capacitance can be increased by making dielectric 21 thick and making dielectric 21 have a multilayer structure, and both the high-withstand voltage and high capacitance can be achieved.

In variable capacitive element 100, because gate electrode 2 (control electrode terminal 2a) of switch portion 10 is electrically separated from terminal electrode 5a (first terminal electrode) and terminal electrode 22 (second terminal electrode) of element portion 20, the operation of switch portion 10 is not affected by the signal on the side on element portion 20. As can be seen from the circuit diagram in Fig. 3, terminal electrode 5a (first terminal electrode) of variable capacitive element 100 and a terminal 22a of terminal electrode 22 (second terminal electrode) are connected to a converter circuit or the like, while control electrode terminal 2a varying the capacitance is connected to a circuit different from the converter circuit. For this reason, there is a low possibility that the signal applied to control electrode terminal 2a is affected by the signal of the converter circuit.

Furthermore, in variable capacitive element 100, the electric resistance of channel formation film 4 between source electrode 5 and drain electrode 6 can be reduced by shortening channel length L of switch portion 10. Consequently, in variable capacitive element 100, improvement of the switching speed (time constant) of switch portion 10 can be coped with in order to vary the capacitance at a high speed.

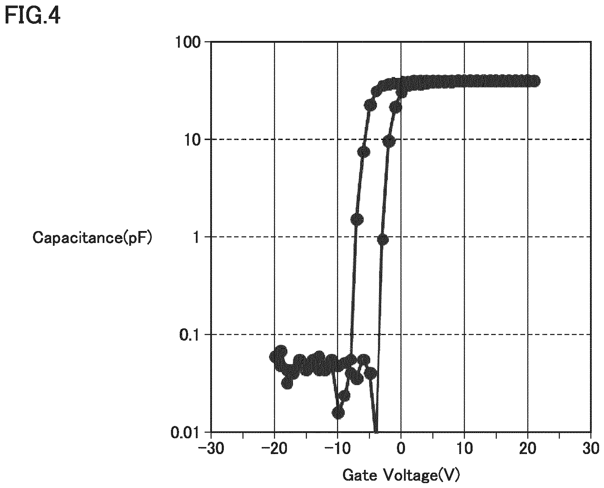

The width of the capacitance that can be varied by variable capacitive element 100 will be described below. Fig. 4 is a graph illustrating a width of a variable capacitance of variable capacitive element 100 according to the first embodiment. The width of the capacitance that can be varied by variable capacitive element 100 depends on the capacitance of the second capacitor as described above. That is, the wider the portion C2 where drain electrode 6 and terminal electrode 22 overlap each other in planar view, the larger the capacitance of the second capacitor, and the wider the capacitance that can be varied by variable capacitive element 100.

The graph illustrated in Fig. 4 is an actual measurement value of variable capacitive element 100 in which an area of the portion C2 where drain electrode 6 and terminal electrode 22 overlap each other in planar view is 1000 times (area ratio 1000 times) an area of the portion C 1 where source electrode 5 and terminal electrode 22 overlap each other in planar view. In Fig. 4, a horizontal axis represents the applied voltage (unit: V) of gate electrode 2, and a vertical axis represents the capacitance (unit: pF) of variable capacitive element 100.

When variable capacitive element 100 designed such that the capacitance of only the first capacitor becomes 0.048 pF and such that the capacitances of the first capacitor and the second capacitor become 48 pF is actually measured, the capacitance became 0.052 pF when the applied voltage of the gate electrode 2 is less than the threshold and the capacitance became 41 pF when the applied voltage is greater than or equal to the threshold as illustrated in Fig. 4. In variable capacitive element 100, a modulation factor of the capacitance was 41 / 0.052 = 788.5, which was about 800 times.

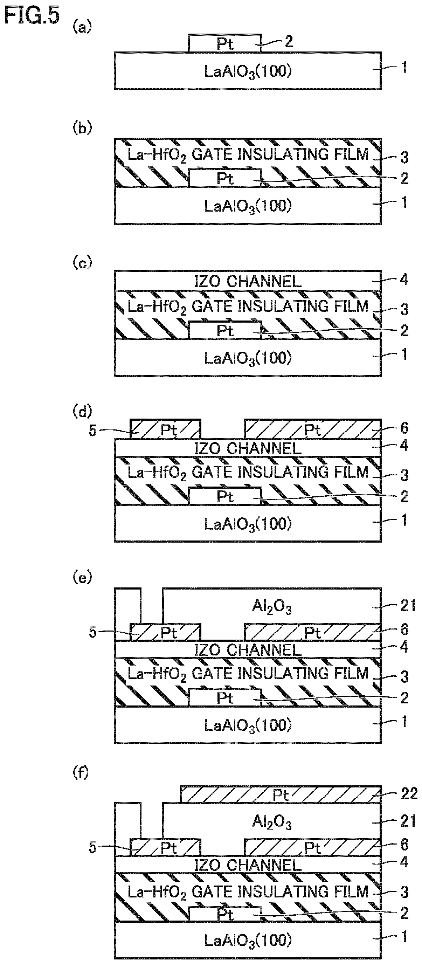

With reference to the drawings, a method of manufacturing variable capacitive element 100 will be described below. Fig. 5 is a sectional view illustrating the method for manufacturing the variable capacitive element of the first embodiment. First, in Fig. 5(a), gate electrode 2 of platinum (Pt) having the film thickness of 80 nm is formed on a (100) plane of prepared lanthanum aluminate (LAO) semiconductor substrate 1. Specifically, gate electrode 2 is formed by forming a photoresist of a predetermined pattern on the (100) plane of the semiconductor substrate 1 using a photolithography technique, and then forming a film of platinum (Pt) by radio-frequency (RF) sputtering, and removing the photoresist by lift-off.

In Fig. 5(b), gate insulating film 3 having the film thickness of 70 nm is formed to overlap the surface of semiconductor substrate 1 on which gate electrode 2 is formed. Specifically, gate insulating film 3 is formed by spin-coating a La-HfO$_2$ solution on the surface of semiconductor substrate 1 on which gate electrode 2 is formed using a chemical solution deposition (CSD) method, drying the film at 150°C, and then firing the film at 800°C in an oxygen atmosphere to crystallize the film.

In Fig. 5(c), channel formation film 4 having the film thickness of 25 nm is formed to overlap gate insulating film 3. Specifically, channel formation film 4 is formed by spin-coating an IZO solution on gate insulating film 3 using the chemical solution deposition method (CSD), drying the film at 150°C, and then firing the film at 500°C in an oxygen atmosphere to crystallize the film.

In Fig. 5(d), platinum (Pt) source electrode 5 and platinum (Pt) drain electrode 6 each having the thickness of 80 nm are formed on channel formation film 4. Specifically, source electrode 5 and drain electrode 6 are formed by forming a photoresist of a predetermined pattern on channel formation film 4 using a photolithography technique, then forming the film of platinum (Pt) by radio-frequency (RF) sputtering, and removing the photoresist by lift-off.

In Fig. 5(e), dielectric 21 is formed of the Al$_2$O$_3$ film having the film thickness of 500 nm on source electrode 5 and drain electrode 6. Specifically, dielectric 21 is formed by forming the photoresist of a predetermined pattern on source electrode 5 and drain electrode 6 using the photolithography technique, then forming the Al$_2$O$_3$ film by electron cyclotron resonance (ECR) sputtering, and removing the photoresist by lift-off.

In Fig. 5(f), terminal electrode 22 of platinum (Pt) having the film thickness of 80 nm is formed on dielectric 21. Specifically, terminal electrode 22 is formed by forming the photoresist of the predetermined pattern on dielectric 21 using the photolithography technique, then forming the film of platinum (Pt) by radio-frequency (RF) sputtering, and removing the photoresist by lift-off.

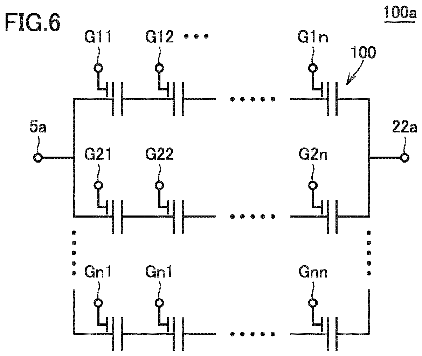

In variable capacitive element 100 described so far, the element in which the capacitance is varied by two values of the capacitance of only the first capacitor and the combined capacitance of the first capacitor and the second capacitor has been described. However, a multi-valued variable capacitive element can be configured by forming a plurality of variable capacitive elements 100 in a matrix shape on semiconductor substrate 1. Fig. 6 is a circuit diagram illustrating a multi-valued variable capacitive element 100a of the first embodiment. A multi-valued variable electronic element can be similarly configured by forming a plurality of variable electronic elements such as inductors and resistors other than capacitors as the included passive elements in a matrix shape.

Fig. 6 illustrates a circuit diagram of variable capacitive element 100a in which n × n variable capacitive elements 100 in Fig. 3 are connected in the matrix shape. In variable capacitive element 100a of Fig. 6, terminal electrode 5a (first terminal electrode) and terminals 22a of terminal electrode 22 (second terminal electrode) are common to n × n variable capacitive elements 100. However, control electrode terminal 2a of each of n × n variable capacitive elements 100 is provided separately, and terminals G11 to Gnn are illustrated in Fig. 6. By supplying signals to terminals G11 to Gnn, a required number of variable capacitive elements 100 can be turned on to obtain a required capacitance, so that variable capacitive element 100a can make variable capacitances multi-valued.

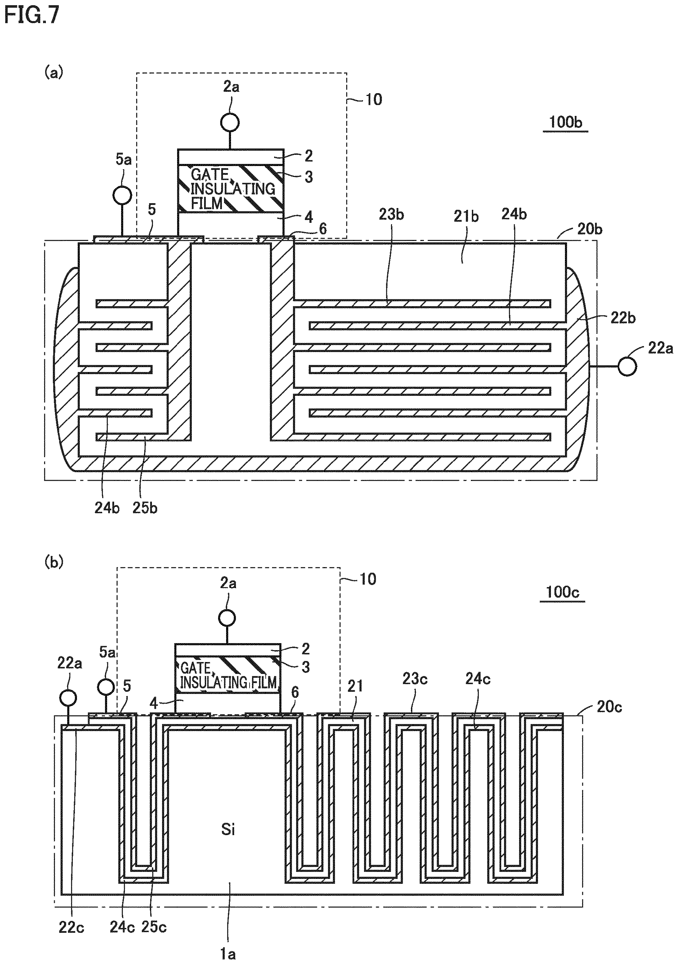

Furthermore, in variable capacitive element 100, the configuration in which element portion 20 is provided on switch portion 10 as illustrated in Fig. 1 has been described. However, element portion 20 may be provided below switch portion 10. Specifically, the variable capacitive element in which element portion 20 is provided under switch portion 10 will be described. Fig. 7 is a sectional view illustrating configurations of variable capacitive elements 100b, 100c according to a modification of the first embodiment. In variable capacitive elements 100b, 100c of Fig. 7, the same components as those of variable capacitive element 100 in Fig. 1 are denoted by the same reference numerals, and the detailed description thereof will not be repeated.

Fig. 7(a) illustrates a variable capacitive element 100b in which a multi-layer ceramic capacitor (MLCC) is used for element portion 20b. In variable capacitive element 100b, source electrode 5 and drain electrode 6 are formed on the upper surface of the multi-layer ceramic capacitor of element portion 20b, and channel formation film 4, gate insulating film 3, and gate electrode 2 are formed on source electrode 5 and drain electrode 6 in this order to constitute switch portion 10.

The multi-layer ceramic capacitor of element portion 20b includes a portion of the first capacitor connected to source electrode 5 and a portion of the second capacitor connected to drain electrode 6. The portion of the first capacitor has a configuration in which a plurality of electrodes 25b connected to source electrode 5 and an electrode 24b connected to a terminal electrode 22b that is an external electrode of the multi-layer ceramic capacitor are laminated with, for example, a dielectric 21b of barium titanate interposed therebetween. In addition, the portion of the second capacitor has a configuration in which a plurality of electrodes 23b connected to drain electrode 6 and electrodes 24b connected to terminal electrode 22b are laminated with dielectric 21b interposed therebetween.

In variable capacitive element 100b, similarly to variable capacitive element 100, when switch portion 10 is in the off state, a gate voltage greater than or equal to the threshold is not applied to gate electrode 2, so that the electron depletion layer exists at the position of channel formation film 4 overlapping gate electrode 2 in planar view and source electrode 5 and drain electrode 6 are not electrically connected. Therefore, the voltage is applied only to dielectric 21b between electrode 25b connected to source electrode 5 and electrode 24b connected to terminal electrode 22b, so that variable capacitive element 100b has the capacitance of only the first capacitor.

On the other hand, in variable capacitive element 100b, when switch portion 10 is in the on state, the channel is formed by applying the gate voltage greater than or equal to the threshold to gate electrode 2, and source electrode 5 and drain electrode 6 are electrically connected. Consequently, the voltage is applied to dielectric 21b between electrode 25b connected to source electrode 5 and electrode 23b connected to drain electrode 6, and electrode 24b connected to terminal electrode 22b, so that variable capacitive element 100b has the combined capacitance of the first capacitor and the second capacitor.

Various configurations such as low temperature co-fired ceramics (LTCC) and high temperature co-fired ceramics (HTCC) can be applied to the portion of the multi-layer ceramic capacitor of element portion 20b.

Fig. 7(b) illustrates a variable capacitive element 100c using a silicon capacitor as an element portion 20c. In variable capacitive element 100c, source electrode 5 and drain electrode 6 are formed on the upper surface of the silicon capacitor of element portion 20c, and channel formation film 4, gate insulating film 3, and gate electrode 2 are formed thereon in this order to configure switch portion 10.

The silicon capacitor of element portion 20c is formed by a semiconductor process, and is configured of an N+ layer 24c formed by implanting n-type impurity ions into a silicon substrate 1a, a dielectric 21c formed on the surface of N+ layer, and a polysilicon layer 23c that is formed on the surface of dielectric 21c and connected to a polysilicon layer 25c connected to source electrode 5 or drain electrode 6. For example, dielectric 21c is made of an inorganic material such as silicon oxide, silicon nitride, hafnium oxide, hafnium silicate, alumina, or barium titanate formed by a chemical vapor deposition (CVD) method. A plurality of trenches or a plurality of pillars are formed in silicon substrate 1a to form an uneven shape.

The silicon capacitor of element portion 20c includes a portion of the first capacitor connected to source electrode 5 and a portion of the second capacitor connected to drain electrode 6. The portion of the first capacitor is configured of a portion of dielectric 21c sandwiched between polysilicon layer 25c connected to source electrode 5 and N+ layer 24c connected to terminal electrode 22c. The portion of the second capacitor is configured of a portion of dielectric 21c sandwiched between polysilicon layer 23c connected to drain electrode 6 and N+ layer 24c connected to terminal electrode 22c.

In variable capacitive element 100c, similarly to variable capacitive element 100, when switch portion 10 is in the off state, the gate voltage greater than or equal to the threshold is not applied to gate electrode 2, so that the electron depletion layer exists at the position of channel formation film 4 overlapping gate electrode 2 in planar view and source electrode 5 and drain electrode 6 are not electrically connected. Therefore, the voltage is applied only to a portion of dielectric 21c sandwiched between polysilicon layer 25c connected to source electrode 5 and N+ layer 24c connected to terminal electrode 22c, so that variable capacitive element 100c has the capacitance of only the first capacitor.

On the other hand, in variable capacitive element 100c, when switch portion 10 is in the on state, the channel is formed by applying the gate voltage greater than or equal to the threshold to gate electrode 2, and source electrode 5 and drain electrode 6 are electrically connected. Accordingly, the voltage is applied to a portion of dielectric 21c sandwiched between polysilicon layer 25c connected to source electrode 5 and polysilicon layer 23c connected to drain electrode 6, and N+ layer 24c connected to terminal electrode 22c, so that variable capacitive element 100c becomes the combined capacitance of the first capacitor and the second capacitor.

In the silicon capacitor of element portion 20c, the capacitance of element portion 20c is increased by providing an uneven portion in silicon substrate 1a. However, dielectric 21c may have a parallel flat plate shape as long as the required capacitance can be secured.

As described above, variable capacitive element 100 of the first embodiment includes switch portion 10 configuring the field effect transistor, and element portion 20 that is electrically connected to switch portion 10 and configures the capacitor (passive element). Switch portion 10 includes source electrode 5, drain electrode 6, channel formation film 4 formed so as to overlap at least a part of source electrode 5 and a part of drain electrode 6, gate insulating film 3 formed so as to overlap channel formation film 4, and gate electrode 2 formed so as to overlap gate insulating film 3. Element portion 20 includes terminal electrode 5a (first terminal electrode) electrically connected to source electrode 5, and terminal electrode 22 (second terminal electrode) that configures the first capacitor (first passive element) with source electrode 5 and configures the second capacitor (second passive element) at least with drain electrode 6. Consequently, variable capacitive element 100 can change the capacitance of the capacitor by switching between the case where element portion 20 is configured by the first capacitor and the case where element portion 20 is configured by the first capacitor and the second capacitor by turning on and off of switch portion 10. Switch portion 10 is preferably provided on the upper portion or the lower portion of element portion 20.

Thus, in variable capacitive element 100 of the first embodiment, the first capacitor is configured between source electrode 5 and terminal electrode 22, and the second capacitor is configured between drain electrode 6 and terminal electrode 22, so that the range in which the capacitance of the capacitor can be varied can be widened and the sufficient withstand voltage can be obtained without reducing the capacitance of the capacitor.

Preferably, element portion 20 further includes dielectric 21 provided so as to overlap source electrode 5 and drain electrode 6, dielectric 21 between source electrode 5 and terminal electrode 22 configures the first capacitor serving as the first passive element, and at least dielectric 21 between drain electrode 6 and terminal electrode 22 configures the second capacitor serving as the second passive element.

Preferably, gate electrode 2 is formed on semiconductor substrate 1, gate insulating film 3 is formed on gate electrode 2 and semiconductor substrate 1, channel formation film 4 is formed on gate insulating film 3, source electrode 5 and drain electrode 6 are formed on channel formation film 4, dielectric 21 is formed on source electrode 5 and drain electrode 6, and terminal electrode 22 is formed on dielectric 21.

(Second embodiment)

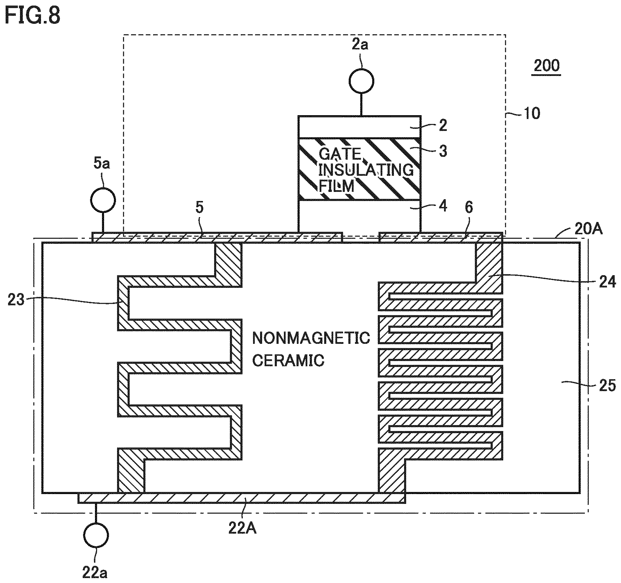

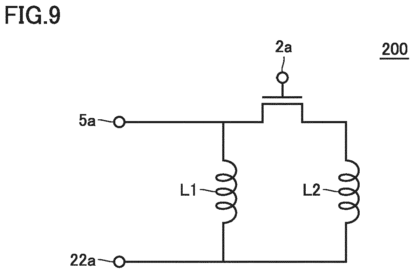

In the variable electronic element of the first embodiment, the included passive element is the capacitor, and the variable capacitive element capable of varying the capacitance has been described. However, the included passive element is not limited to the capacitor. In a variable electronic element according to a second embodiment, the included passive element is an inductor, and a variable inductance element capable of varying inductance will be described with reference to the drawings. Fig. 8 is a sectional view illustrating a configuration of a variable inductance element 200 of the second embodiment. Fig. 9 is a circuit diagram illustrating variable inductance element 200 of the second embodiment. In variable inductance element 200 of Figs. 8 and 9, the same components as those of variable capacitive element 100 of Figs. 1 and 3 are denoted by the same reference numerals, and a detailed description thereof will not be repeated.

Variable inductance element 200 in Fig. 8 includes switch portion 10 configuring the field effect transistor, and an element portion 20A that is electrically connected to switch portion 10 and configures the passive element. Element portion 20A is provided below switch portion 10.

Switch portion 10 includes a gate electrode 2, a gate insulating film 3, a channel formation film 4, a source electrode 5, and a drain electrode 6. In switch portion 10 of Fig. 8, source electrode 5 and drain electrode 6 are formed on the upper surface of element portion 20A, and channel formation film 4, gate insulating film 3, and gate electrode 2 are formed on source electrode 5 and drain electrode 6 in this order to configure switch portion 10.

As illustrated in Fig. 8, in variable inductance element 200, element portion 20A is an inductor, and includes a portion of the first inductor connected to source electrode 5 and a portion of the second inductor connected to drain electrode 6. The portion of the first inductor includes a coil electrode 23 connected to source electrode 5 and a terminal electrode 22A that is an external electrode of the inductor. The portion of the second inductor includes a coil electrode 24 connected to drain electrode 6 and terminal electrode 22A that is the external electrode of the inductor. Coil electrode 23 and coil electrode 24 are formed in the same nonmagnetic ceramic 25. Although terminal electrode 5a (first terminal electrode) is provided on source electrode 5 in Fig. 8, source electrode 5 itself may be used as terminal electrode 5a. Although control electrode terminal 2a is provided on gate electrode 2 in Fig. 8, gate electrode 2 itself may be used as control electrode terminal 2a. Furthermore, although terminal 22a of terminal electrode 22A is provided on terminal electrode 22A in Fig. 8, terminal electrode 22A itself may be used as terminal 22a.

In variable inductance element 200, similarly to variable capacitive element 100, when switch portion 10 is in the off state, the gate voltage greater than or equal to the threshold is not applied to gate electrode 2, so that the electron depletion layer at the position of channel formation film 4 overlapping gate electrode 2 in planar view and source electrode 5 and drain electrode 6 are not electrically connected. Consequently, the current flows only through coil electrode 24 between source electrode 5 and terminal electrode 22A, so that variable inductance element 200 has the inductance of only the first inductor.

On the other hand, in the variable inductance element 200, when switch portion 10 is in the on state, the channel is formed by applying the gate voltage greater than or equal to the threshold to gate electrode 2, and source electrode 5 and drain electrode 6 are electrically connected. Consequently, the current flows through coil electrode 23 between source electrode 5 and terminal electrode 22A, and coil electrode 24 between drain electrode 6 and terminal electrode 22A, so that variable inductance element 200 has the combined inductance of the first inductor and the second inductor.

As can be seen from the circuit diagram in Fig. 9, in variable inductance element 200, terminal electrode 5a (first terminal electrode) and terminal 22a of terminal electrode 22A (second terminal electrode) are connected to the converter circuit or the like, and control electrode terminal 2a varying the inductance is connected to a circuit different from the converter circuit. For this reason, there is a low possibility that the signal applied to control electrode terminal 2a is affected by the signal of the converter circuit.

As described above, in variable inductance element 200 of the second embodiment, the passive element is an inductor, and element portion 20A includes the first inductor that is electrically connected between source electrode 5 and terminal electrode 22A and serves as the first passive element, and the second inductor that is electrically connected between drain electrode 6 and terminal electrode 22A and serves as the second passive element.

Thus, in variable inductance element 200 of the second embodiment, the first inductor is configured between source electrode 5 and terminal electrode 22A, and the second inductor is configured between drain electrode 6 and terminal electrode 22A, so that the range in which the inductance of the inductor can be varied can be widened and the sufficient withstand voltage can be obtained without reducing the inductance of the inductor.

A multi-valued variable inductance element may be configured by forming a plurality of variable inductance elements 200 in a matrix shape. In addition, by changing coil electrodes 23, 24 in Fig. 8 to resistance elements, the passive element may be used as a variable resistor element as a resistor. Furthermore, the configuration of switch portion 10 described in the first embodiment and the second embodiment is not limited to the described configuration, but for example, may be a silicon MOSFET, a GaNFET, or the like.

(Third embodiment)

As described in the first embodiment and the second embodiment, variable capacitive elements 100, 100a and variable inductance element 200 have, due to the configuration thereof, the wide width in which the physical quantity of the passive element can be varied, and have the characteristic in which the sufficient withstand voltage can be obtained without reducing the physical quantity of the passive element. A circuit device including variable capacitive element 100, 100a and variable inductance element 200 using this characteristic will be described below.

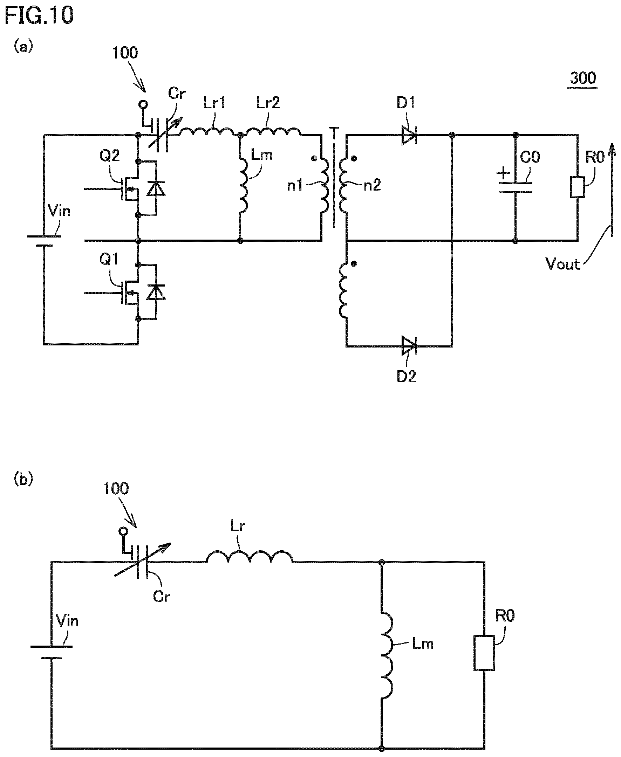

Fig. 10 is a circuit diagram illustrating a circuit device according to a third embodiment. Fig. 10(b) is an equivalent circuit in Fig. 10(a). A circuit device 300 in Fig. 10(a) is a circuit that adjusts an output level according to a load variation, and is an LLC resonance converter. Circuit device 300 that is the LLC resonant converter can convert an input voltage Vin into an output voltage Vout. Circuit device 300 includes switching elements Q1, Q2, a transformer T, a resonance capacitor Cr, leakage inductors Lr, Lr1, Lr2, an excitation inductor Lm, output rectifier diodes D1, D2, and an output capacitor C0. Output capacitor C0 is connected to a load resistor R0.

An input-output voltage ratio (|Vout / Vin|) of circuit device 300 that is the LLC resonant converter can be expressed as (Equation 1).

[Mathematical formula 1]

$$\frac{|Vout|}{|Vin|} = \frac{1}{\sqrt{\left(1 + \frac{1}{S} - \frac{1}{SF^2}\right)^2 + Q^2\left(F - \frac{1}{F}\right)^2}} \quad \cdots\cdots (Equation\ 1)$$

Variables in (Equation 1) are expressed as (Equation 2) and (Equation 3).
[Mathematical formula 2]

$$S = \frac{L_m}{L_r}\ , \qquad f_r = \frac{1}{2\pi\sqrt{L_m C_r}}\ , \qquad F = \frac{f}{f_r} \quad \cdots\cdots (Equation\ 2)$$

[Mathematical formula 3]

$$R_{ac} = \frac{8}{\pi^2}\left(\frac{n_1}{n_2}\right)^2 R_0\ , \qquad Q = \frac{\sqrt{\frac{L_r}{C_r}}}{R_{ac}} \quad \cdots\cdots (Equation\ 3)$$

As can be seen from (Equation 1), the input-output voltage ratio of the LLC resonant converter can be adjusted by modulating a switching frequency f of switching elements Q1, Q2. In the LLC resonant converter, the output voltage (Vout) of the LLC resonant converter is normally adjusted by operating the LLC resonant converter at a frequency greater than or equal to the frequency at which the input-output voltage ratio becomes the maximum value and changing the switching frequency according to a load variation.

For example, when the output voltage (Vout) is lowered, the LLC resonant converter needs to have the switching frequency greater than the frequency at which the input-output voltage ratio becomes a maximum value. However, because the power loss of the LLC resonant converter depends on the switching frequency, there is a problem that the power loss increases when the switching frequency is increased to lower the output voltage (Vout) of the LLC resonant converter.

Accordingly, in circuit device 300, variable capacitive element 100 of the first embodiment is used for resonance capacitor Cr in order to lower the output voltage (Vout) of the LLC resonance converter without increasing the switching frequency. Circuit device 300 can lower the output voltage (Vout) without increasing the switching frequency by using variable capacitive element 100 as resonance capacitor Cr.

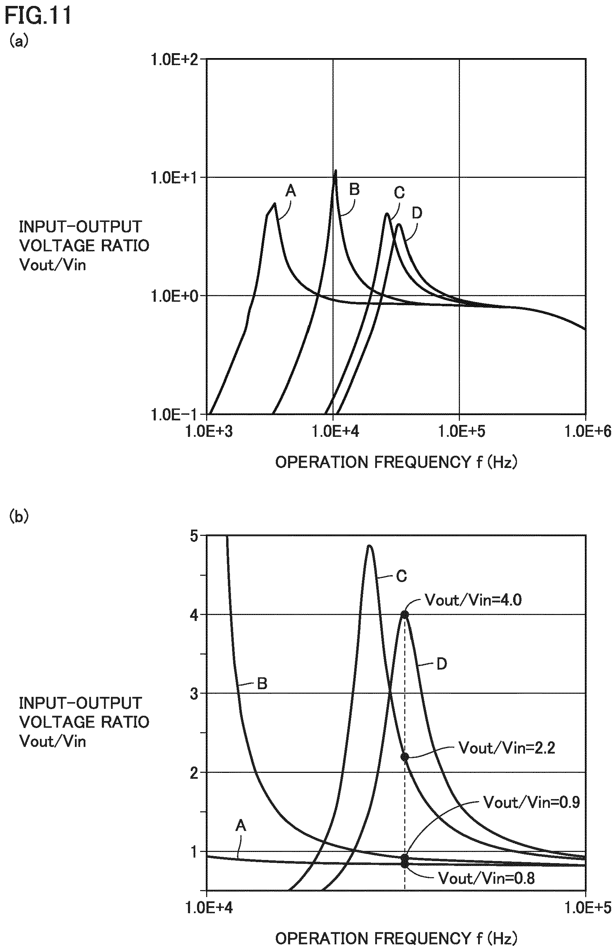

Fig. 11 is a graph illustrating a frequency characteristic of circuit device 300 of the third embodiment. Fig. 11(a) illustrates frequency characteristics of the input-output voltage ratio when the capacitance is 1.5 times, 10 times, and 100 times the capacitance of resonance capacitor Cr (for example, 0.02 $\mu$F). Fig. 11(b) is an enlarged view of a part of the graph in Fig. 11(a). In Figs. 11(a) and 11(b), the horizontal axis represents an operation frequency (unit: Hz), and the vertical axis represents the input-output voltage ratio.

In Figs. 11(a) and 11(b), the frequency characteristic of the input-output voltage ratio when the capacitance of resonance capacitor Cr is 100 times is a graph A, and the capacitance of resonance capacitor Cr is 10 times is a graph B. In Figs. 11(a) and 11(b), a graph C illustrates the frequency characteristic of the input-output voltage ratio when the capacitance of the resonance capacitor Cr is increased by 1.5 times, and a graph D illustrates the frequency characteristic of the input-output voltage ratio when the capacitance of resonance capacitor Cr remains.

As illustrated in Fig. 11(b), the input-output voltage ratios illustrated when graphs A to D have the same operation frequency (the frequency indicated by a broken line) greatly change. Specifically, the input-output voltage ratio of graph D is |Vout / Vin| = 4.0, and the input-output voltage ratio of graph C is |Vout / Vin| = 2.2. The input-output voltage ratio of graph B is |Vout / Vin| = 0.9, and the input-output voltage ratio of graph A is |Vout / Vin| = 0.8. That is, by varying the capacitance of resonance capacitor Cr by about 10 times, the input-output voltage ratio can be changed in the range of 4.0 to 0.9 without changing the operating frequency.

As described above, using variable capacitive element 100 as resonance capacitor Cr of circuit device 300, the output voltage (Vout) can be lowered without increasing the power loss. In particular, using multi-valued variable capacitive element 100a as resonance capacitor Cr of circuit device 300, the capacitance of resonance capacitor Cr can be dynamically varied, and the input-output voltage ratio can be changed to multiple stages.

(Fourth embodiment)

Soft switching control of the LLC resonant converter will be described below. The LLC resonant converter has a circuit configuration in which the LC resonance is used as illustrated in Fig. 10, and can implement low-loss soft switching by the circuit configuration. In particular, using variable capacitive element 100 as resonance capacitor Cr, for example, even for a switching amplifier (such as a pulse width modulation (PWM) amplifier), the loss at the switching time can be greatly reduced by dynamically changing the capacitance of resonance capacitor Cr.

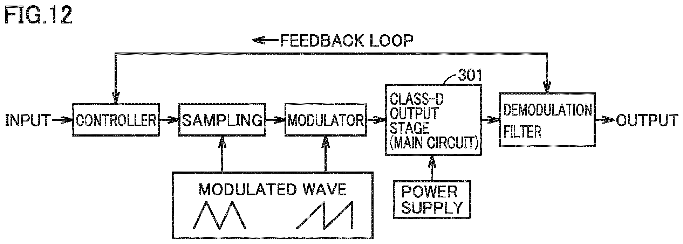

Fig. 12 is a block diagram illustrating a circuit device according to a fourth embodiment. The circuit device in Fig. 12 is a switching amplifier, and uses the LLC resonance converter in which resonance capacitor Cr is used as variable capacitive element 100 for a class-D output stage 301. In class-D output stage 301, by dynamically changing the capacitance value of resonance capacitor Cr (variable capacitive element 100), the capacitive impedance after class-D output stage 301 can be reduced to implement the low-loss soft switching.

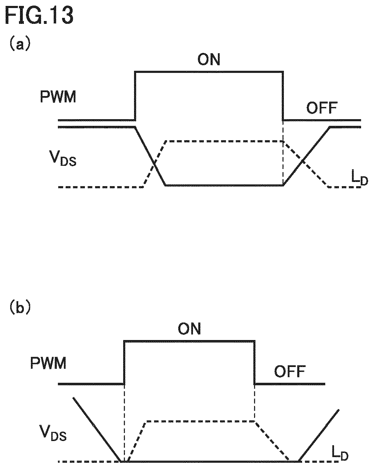

With reference to the drawings, the LLC resonant converter that implements the low-loss soft switching will be further described in detail. Fig. 13 is a timing chart illustrating switching timing of the circuit device of the fourth embodiment. In the normal switching, as illustrated in Fig. 13(a), the switching between a voltage $V_{DS}$ and a current $I_D$ is generated at the same time, and falling of the current $I_D$ is delayed with respect to the off time of the PWM, so that a switching loss (P = IV) is generated at a portion where voltage $V_{DS}$ and current $I_D$ intersect with each other. The switching in Fig. 13(a) is referred to as hard switching.

On the other hand, in the LLC resonance converter, by vibrating the voltage and the current at the LC resonance frequency, as illustrated in Fig. 13(b), the PWM can be turned on (zero voltage switching (ZVS)) in the state where voltage $V_{DS}$ is zero. In addition, in the LLC resonance converter, by vibrating the voltage and the current at the LC resonance frequency, the PWM can be turned on (zero current switching (ZCS)) in the state where the current $I_D$ is zero. Consequently, the switching loss can be reduced in the LLC resonance converter. The switching Fig. 13(b) is referred to as soft switching.

The LLC resonant converter (circuit device 300) in Fig. 10 has two resonance frequencies of a resonance frequency fr of resonance capacitor Cr and leakage inductor Lr and a resonance frequency fm of resonance capacitor Cr, leakage inductor Lr, and excitation inductor Lm. In circuit device 300 that is the LLC resonant converter, a condition that the soft switching state is established is determined by the relationship between resonance frequencies fr, fm and switching frequency f. For example, when switching frequency f is lower than resonance frequency fm (f < fm), circuit device 300 satisfies the hard switching condition. However, this condition is not normally used because gain inversion is generated.

In addition, when switching frequency f is larger than resonance frequency fm and is smaller than resonance frequency fr (fm < f < fr), circuit device 300 satisfies the soft switching condition. Furthermore, when switching frequency f is equal to resonance frequency fr (f = fr), circuit device 300 satisfies the hard switching condition. In addition, when switching frequency f is greater than resonance frequency fr (fr < f), circuit device 300 satisfies the soft switching condition.

In circuit device 300 that is the LLC resonance converter, the condition that the soft switching state is satisfied varies depending on the load condition and is determined by conditional expressions illustrated in (Expression 4) and (Expression 5).

[Mathematical formula 4]

$$|Vin - Vcr| \times \frac{L_m}{L_r + L_m} < Vout \times \frac{n_1}{n_2} \quad \cdots\cdots\cdots (\text{Equation } 4)$$

[Mathematical formula 5]

$$|Vin - Vcr| \times \frac{L_m}{L_r + L_m} > Vout \times \frac{n_1}{n_2} \quad \cdots\cdots\cdots (\text{Equation } 5)$$

When the conditional expression of (Expression 4) is satisfied, an output rectifier diode D2 is not conducted, so that the soft switching state is established in circuit device 300. On the other hand, when the conditional expression of (Expression 5) is satisfied, output rectifier diode D2 is conducted, so that the soft switching state is not established in circuit device 300.

For example, when Vout is constant, the condition under which the soft switching is established changes due to a variation in Vin or voltage Vcr of resonance capacitor Cr, so that the condition under which the switching loss increases is generated in circuit device 300. Here, voltage Vcr varies depending on the load condition and the capacitance of resonance capacitor Cr. Consequently, in circuit device 300, the control under the condition that soft switching is satisfied can be performed by varying the capacitance using variable capacitive element 100 as resonance capacitor Cr.

In circuit device 300, variable capacitive element 100 is used for resonance capacitor Cr. As described in the first embodiment, variable capacitive element 100 has a wider variable capacitance range than the conventional variable capacitive element, so that large fluctuations in input voltage Vin and the load condition can be coped with.

As described above, using variable capacitive element 100 for resonance capacitor Cr of circuit device 300, the capacitance of resonance capacitor Cr can be greatly varied, and a wide range of the conditions that the soft switching holds can be secured. In particular, using multi-valued variable capacitive element 100a as resonance capacitor Cr of circuit device 300, the capacitance of resonance capacitor Cr can be dynamically varied, and the condition that the soft switching is satisfied can be adjusted in multiple stages.

The same effect can be obtained using the variable inductance element described in the second embodiment for leakage inductor Lr and excitation inductor Lm in addition to the use of variable capacitive element 100 for resonance capacitor Cr of circuit device 300. In addition, the circuit device capable of adjusting the condition that the soft switching is satisfied by varying resonance capacitor Cr or the like is not limited to circuit device 300 that is the LLC resonance converter, and can also be applied to circuit devices of various resonance systems such as a current resonance circuit, a voltage resonance circuit, a multiple resonance circuit, a series resonance circuit, and a parallel resonance circuit.

(Fifth embodiment)

A circuit configuration in which the variable capacitive element described in the first embodiment and the variable inductance element described in the second embodiment are applied to a multi-band wireless communication terminal will be described below. With the spread of the Internet of Things (IoT), in a wireless communication system, it is desired to provide an optimal communication characteristic according to each condition such as a place to be used, time, available frequency, and a required signal transmission speed. For example, in the wireless communication system, a very wide frequency band of about several 10 MHz to 5 GHz is required to be used in one wireless communication terminal in order to communicate large-capacity and high-density data.

For this reason, in the wireless communication terminal, a plurality of RF circuits that needs to be multi-band and correspond to each frequency are required to be provided, and the RF circuit to be used is required to be appropriately switched. However, when the plurality of RF circuits are provided, the wireless communication terminal increases in a circuit scale and the number of components, and it becomes difficult to reduce the size and cost of the terminal.

Accordingly, in the wireless communication terminal, the circuit scale and the number of components are required to be reduced by sharing a circuit block for a plurality of frequencies. However, when the circuit block is shared for the plurality of frequencies, signal reflection between the circuit blocks is required to be prevented, and impedance matching is required to be performed according to each frequency. In addition, in order to share the reception antenna of the wireless communication terminal, the resonance frequency of the antenna is required to be significantly modulated. In the wireless communication terminal, when the capacitance value of the capacitor is varied in order to perform the impedance matching and modulation of the resonance frequency, a plurality of frequency bands can be covered while the circuit scale and the number of components are reduced.

Variable capacitive element 100 of the first embodiment can have the wider range of capacitance that can be varied than the conventional variable capacitive element. Consequently, the wireless communication terminal using variable capacitive element 100 can cover the wide frequency band. In addition, the capacitance value of variable capacitive element 100 is switched by the voltage applied to the control electrode terminal 2a, so that the capacitance value does not change nonlinearly (gently) with respect to the voltage unlike the conventional variable capacitive element. For this reason, in the wireless communication terminal using variable capacitive element 100, a distortion signal is not generated, and a disturbance signal is not generated for other frequencies.

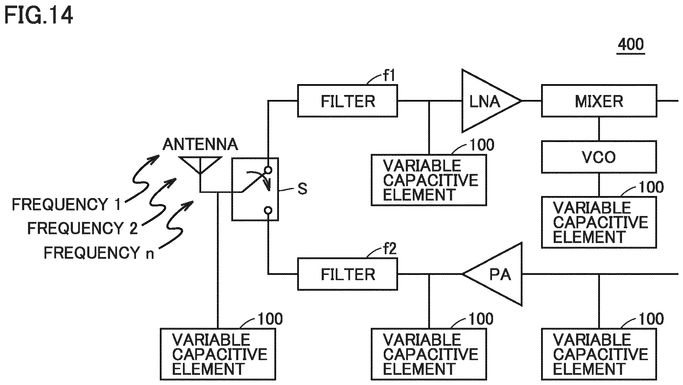

Fig. 14 is a block diagram illustrating a circuit device 400 according to a fifth embodiment. Circuit device 400 is a communication circuit block provided in the wireless communication terminal, and can be used for sharing a plurality of frequencies. For this reason, in circuit device 400, variable capacitive element 100 is applied to the capacitor in which the capacitance value is required to be variable in order to perform the impedance matching and the modulation of the resonance frequency.

In circuit device 400, variable capacitive element 100 can vary the capacitance in the range of 10 times to 1000 times, so that the impedance matching and the modulation of the resonance frequency can be performed in the wider range to cover a wider reception frequency band. Furthermore, in circuit device 400, variable capacitive element 100 digitally varies the capacitance, so that the distortion signal can be prevented. Consequently, using circuit device 400, the multi-band wireless communication terminal capable of covering the plurality of frequency bands can be implemented while the circuit scale and the number of components are reduced. Multi-valued variable capacitive element 100a may be used for the capacitor of circuit device 400.

(Sixth embodiment)

A configuration in which the loss is reduced using the variable capacitive element described in the first embodiment in a DC circuit breaker will be described. The configuration of the DC circuit breaker can be similarly applied to switches, connection devices, and arc prevention devices of various power supply circuits. In addition, for example, the DC circuit breaker can be used in a DC power supply device such as an energy harvesting device such as solar power generation, a fuel cell, or a lithium ion cell.

In the DC circuit breaker, a power semiconductor switch using silicon carbide (SiC) or gallium nitride (GaN) capable of high-withstand voltage, high temperature operation, and high speed operation as compared with the MOSFET is expected to be used instead of the metal contact. However, the switching of about several 100 V to several 10 A is possible when a power semiconductor switch is used in the DC circuit breaker instead of the metal contact, but there is a problem that an energization loss due to heat generation at the time of energization of the semiconductor becomes very large and the provision of a cooling device is required.

On the other hand, when the metal contact is used for the DC circuit breaker, the energization loss can be reduced, but the loss at the time of off becomes very large because arc discharge is generated at the time of interruption. Accordingly, there has been proposed a DC circuit breaker using a hybrid switch circuit in which the metal contact with the small energization loss is energized at the time of on, and the current is commutated to a semiconductor switch of the MOSFET only at the time of off to prevent the arc discharge. For example, the hybrid switch circuit is described in the document "Ryuichi Shimada, "Smart Switch with Semiconductor Device (Hybrid Switching/Connecting device)", Journal of the Power Electronics Society of Japan, March 2017, Vol. 42, p. 53 -57".

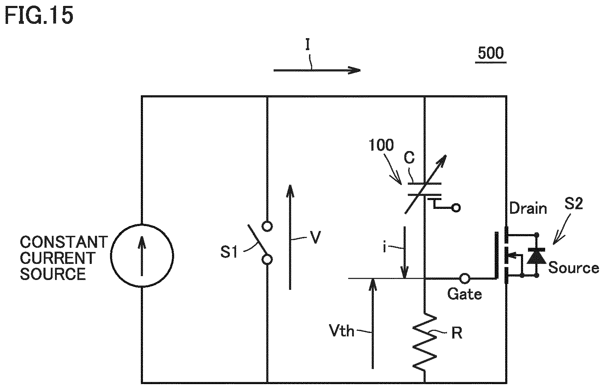

Fig. 15 is a circuit diagram of a circuit device 500 according to a sixth embodiment. Circuit device 500 is a hybrid switch circuit used for the DC circuit breaker, and includes a metal contact S1 and a semiconductor switch S2 of the MOSFET. In circuit device 500, since metal contact S1 can be opened and closed without arc discharge, there is an advantage that no contact exhaustion, a long life, and high-speed current cut off can be performed, and the noise due to the arc discharge is not generated.

In circuit device 500, the current flows through metal contact S1 when metal contact S1 is on, and when metal contact S1 is off, semiconductor switch S2 is turned on at threshold voltage Vth of the MOSFET, and the current flows through semiconductor switch S2. After metal contact S 1 is turned off, re-electromotive voltage V of metal contact S1 is given by (Equation 6). Vth is the threshold voltage of the MOSFET, and t is time.

[Mathematical formula 6]

$$V = \mathrm{Vth} + \frac{Vth}{RC} \times t \quad \cdots\cdots\cdots (\text{Equation } 6)$$

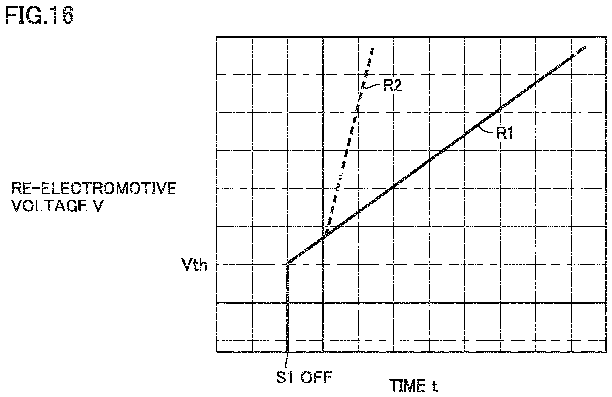

Re-electromotive voltage V of metal contact S1 increases linearly with respect to time t, but energy consumed at this time becomes a circuit loss. Fig. 16 is a graph illustrating a switching characteristic of the circuit device 500 of the sixth embodiment. In Fig. 16, the horizontal axis represents time t, and the vertical axis represents re-electromotive voltage V. As indicated by a graph R1 in Fig. 16, after metal contact S1 is turned off, re-electromotive voltage V of metal contact S1 increases linearly with respect to time t.

For this reason, in order to reduce the circuit loss, desirably re-electromotive voltage V of metal contact S1 rises as sharply as possible after metal contact S1 is turned off. As indicated by graph R2 in Fig. 16, the circuit loss can be reduced by rapidly increasing re-electromotive voltage V of metal contact S1. As can be seen from (Equation 6), the smaller the capacitance of capacitor C, the steeper re-electromotive voltage V rises, and the circuit loss can be reduced. On the other hand, when metal contact S1 is on (and immediately after metal contact S1 is turned off), the capacitance of capacitor C is required to set to the relatively large capacitance (for example, several 10 nF) in order to absorb the electric charge that generates the arc discharge.

Accordingly, in circuit device 500, as illustrated in Fig. 15, the variable capacitive element described in the first embodiment is used for capacitor C such that the capacitance of capacitor C can be largely varied between the on state and the off state of metal contact S1. Consequently, the DC circuit breaker in which the circuit loss is very low while the arc discharge is prevented is implemented in circuit device 500. In the variable capacitive element of the first embodiment, the high-withstand voltage can be obtained while the capacitance is varied in the wide range that has been difficult to be implemented in the conventional variable capacitive element. Multi-valued variable capacitive element 100a may be used for capacitor C of circuit device 500.

(Seventh embodiment)

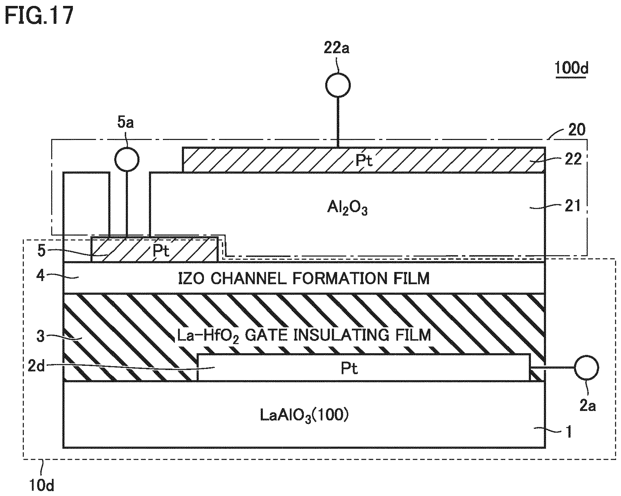

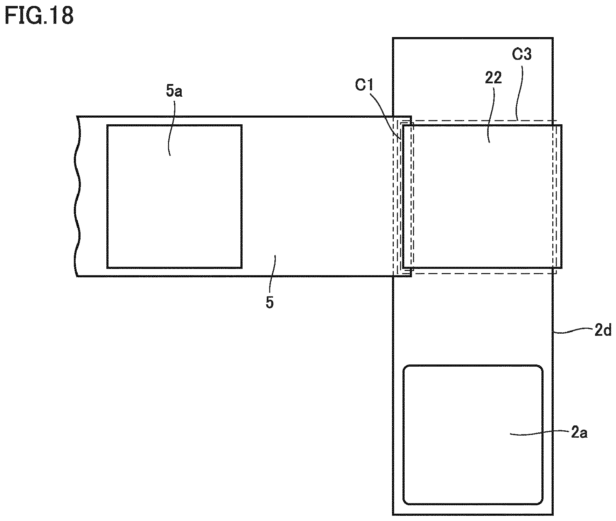

In the first embodiment, it has been described that switch portion 10 included gate electrode 2, gate insulating film 3, channel formation film 4, source electrode 5, and drain electrode 6. Among them, drain electrode 6 is a floating electrode, and can configure a switch portion in which drain electrode 6 not provided. In a variable electronic element according to a seventh embodiment, a configuration in which the drain electrode as the floating electrode is not provided will be described with reference to the drawings. Fig. 17 is a sectional view illustrating a configuration of a variable capacitive element 100d of the seventh embodiment. Fig. 18 is a plan view illustrating the configuration of variable capacitive element 100d of the seventh embodiment. In variable capacitive element 100d of Figs. 17 and 18, the same components as those of variable capacitive element 100 in Figs. 1 and 2 are denoted by the same reference numerals, and the detailed description thereof will not be repeated.

A variable capacitive element 100d in Fig. 17 includes a switch portion 10d configuring the field effect transistor formed on semiconductor substrate 1, and element portion 20 that is electrically connected to switch portion 10d and configures the passive element. Element portion 20 is provided above switch portion 10d.

Switch portion 10d includes a gate electrode 2d, gate insulating film 3, channel formation film 4, and source electrode 5. In switch portion 10d of Fig. 17, gate electrode 2d is formed on semiconductor substrate 1, gate insulating film 3 and channel formation film 4 are sequentially formed so as to overlap gate electrode 2d, and source electrode 5 is formed on gate insulating film 3 and channel formation film 4.

In switch portion 10d, the drain electrode is not provided, but gate electrode 2d is widened as illustrated in Fig. 18, and most of terminal electrode 22 overlaps gate electrode 2d in planar view. Therefore, in variable capacitive element 100d, when switch portion 10d is turned on, the gate voltage is applied to gate electrode 2d, and the channel charges are generated in a portion of channel formation film 4 overlapping gate electrode 2d in planar view. In variable capacitive element 100d, the capacitance is formed by applying the voltage between a portion of source electrode 5 and channel formation film 4, and terminal electrode 22 opposite the portion.

On the other hand, when switch portion 10d is in the off state, no gate voltage is applied to gate electrode 2d in variable capacitive element 100d, so that no channel charge is generated in channel formation film 4. For this reason, because voltage is applied only between source electrode 5 and terminal electrode 22 opposite to source electrode 5, variable capacitive element 100d has the capacitance of only the first capacitor.

Element portion 20 constitutes the first capacitor (first passive element) between source electrode 5 and terminal electrode 22, and configures the second capacitor (second passive element) between gate electrode 2d and terminal electrode 22. Specifically, as illustrated in Fig. 18, the first capacitor is a portion C1 where source electrode 5 and terminal electrode 22 overlap each other in planar view. The second capacitor is a portion C3 where gate electrode 2d and terminal electrode 22 overlap each other in planar view.

Even in variable capacitive element 100d, by turning on and off switch portion 10d, the capacitance of the capacitor can be varied by switching between the case where the first capacitor element is used as element portion 20 and the case where the first capacitor element and the second capacitor element are used as element portion 20. Even variable capacitive element 100d is the variable capacitive element that is divided into switch portion 10d that performs the on and off operation by the voltage applied to gate electrode 2d (control electrode terminal 2a), terminal electrode 5a (first terminal electrode), element portion 20 that operates with terminal electrode 22 (second terminal electrode), and operates with three terminals.

However, in variable capacitive element 100d, because the capacitance of the second capacitor element can be changed by the channel charge generated in channel formation film 4 without providing the drain electrode, the capacitance of the second capacitor element can be continuously varied by the voltage applied to gate electrode 2d. In addition, in variable capacitive element 100d, the residual charge in the floating electrode is reduced at the time of the on and off operation of switch portion 10d by adopting the configuration in which the drain electrode that is the floating electrode is not provided, so that the potential of the capacitor can be stabilized or the failure due to short-circuiting can be reduced. Furthermore, in variable capacitive element 100d, the drain electrode that is the floating electrode is not provided, the conductivity can be varied stepwise in the wide region of channel formation film 4 according to the level of the gate voltage to be applied, so that the capacitance of the capacitor can be changed more continuously.

As described above, variable capacitive element 100d of the seventh embodiment uses the portion C3 where gate electrode 2d and channel formation film 4 overlap each other in planar view instead of the drain electrode. The second capacitor element is formed between portion C3 and terminal electrode 22. Thus, variable capacitive element 100d can continuously vary the capacitance of the second capacitor element.

In variable capacitive element 100d, the configuration in which element portion 20 is provided on switch portion 10d as illustrated in Fig. 17 has been described, but element portion 20 may be provided under switch portion 10d. In addition, a multi-valued variable electronic element may be similarly configured by forming a plurality of variable capacitive elements 100d in a matrix shape. Furthermore, the configuration of variable capacitive element 100d may be applied to a variable electronic element other than a capacitor, such as an inductor or a resistor.

(Eighth embodiment)

In variable capacitive element 100 of the first embodiment, terminal electrode 22 is also formed on the channel region formed between source electrode 5 and drain electrode 6. Accordingly, variable capacitive element 100 sometimes affects the on and off state of switch portion 10 by the voltage applied to terminal 22a of terminal electrode 22. That is, in variable capacitive element 100, there has been a risk that the capacitance value fluctuates due to a signal between terminal electrode 5a (first terminal electrode) and terminal 22a of terminal electrode 22 (second terminal electrode).

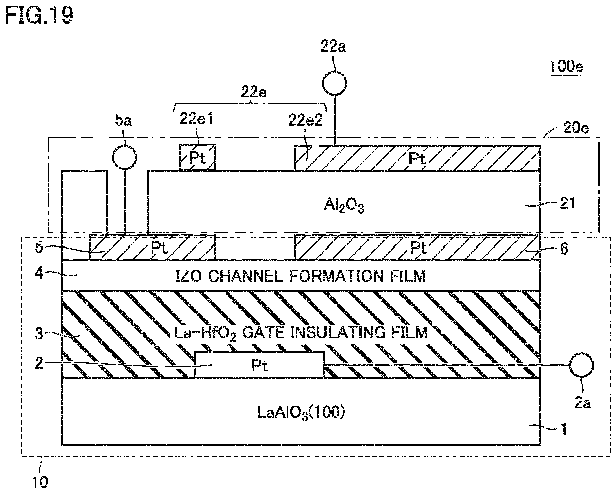

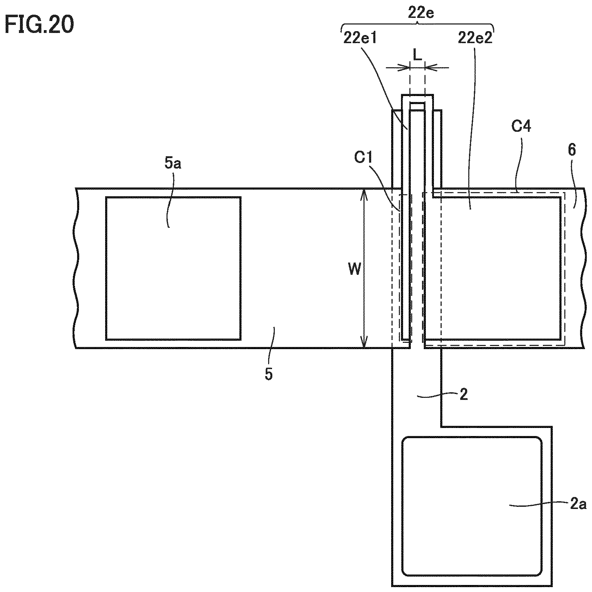

Accordingly, in a variable electronic element according to an eighth embodiment, a configuration in which the capacitance value is less likely to fluctuate by the signal between the first terminal electrode and the second terminal electrode will be described with reference to the drawings. Fig. 19 is a sectional view illustrating a configuration of a variable capacitive element 100e of the eighth embodiment. Fig. 20 is a plan view illustrating the configuration of variable capacitive element 100e of the eighth embodiment. In variable capacitive element 100e of Figs. 19 and 20, the same components as those of variable capacitive element 100 in Figs. 1 and 2 are denoted by the same reference numerals, and the detailed description thereof will not be repeated.

Variable capacitive element 100e in Fig. 19 includes a switch portion 10 configuring a field effect transistor formed on a semiconductor substrate 1 and an element portion 20e that is electrically connected to switch portion 10 and configures the passive element. Element portion 20e is provided above switch portion 10.

Element portion 20e includes the $Al_2O_3$ film of dielectric 21 and a terminal electrode 22e (second terminal electrode) of platinum (Pt) formed to overlap dielectric 21. As illustrated in Fig. 20, terminal electrode 22e is formed in a pattern avoiding the channel region formed between source electrode 5 and drain electrode 6. For this reason, in the sectional view of Fig. 19, a terminal electrode 22e1 formed on the upper portion of source electrode 5 and a terminal electrode 22e2 formed on the upper portion of drain electrode 6 are illustrated separately.

Element portion 20e constitutes the first capacitor (first passive element) between source electrode 5 and terminal electrode 22e1, and configures the second capacitor (second passive element) between drain electrode 6 and terminal electrode 22e2. As illustrated in Fig. 20, the first capacitor is portion C1 where source electrode 5 and terminal electrode 22e1 overlap each other in planar view. The second capacitor is a portion C4 where drain electrode 6 and terminal electrode 22e2 overlap each other in planar view.

In variable capacitive element 100e, when switch portion 10 is in the off state, the gate voltage greater than or equal to the threshold is not applied to gate electrode 2, so that the electron depletion layer exists at the position of channel formation film 4 overlapping gate electrode 2 in planar view and source electrode 5 and drain electrode 6 are not electrically connected. For this reason, the voltage is applied only between source electrode 5 and the portion (first region) of terminal electrode 22e1 opposite to source electrode 5, so that variable capacitive element 100e has the capacitance of only the first capacitor.

However, in variable capacitive element 100e, when switch portion 10 is in the on state, the channel is formed by applying the gate voltage equal to greater than or equal to the threshold to gate electrode 2, and source electrode 5 and drain electrode 6 are electrically connected. For this reason, the voltage is applied between source electrode 5 and drain electrode 6, and terminal electrode 22e (first region + second region) opposite to each other, so that the variable capacitive element 100e has the combined capacitance of the first capacitor and the second capacitor. At this point, in terminal electrode 22e, a portion overlapping source electrode 5 in planar view is referred to as the first region (terminal electrode 22e1), and a portion overlapping the drain electrode in planar view is referred to as the second region (terminal electrode 22e2).

Because terminal electrode 22e does not overlap the channel region formed between source electrode 5 and drain electrode 6 in planar view, the capacitance of variable capacitive element 100e is smaller than that of variable capacitive element 100 in Fig. 1 when switch portion 10 is in the on state. However, as described above, in variable capacitive element 100e, the capacitance value is less likely to fluctuate due to the signal between terminal electrode 5a (first terminal electrode) and terminal 22a of terminal electrode 22 (second terminal electrode). As a matter of course, in variable capacitive element 100e, even when terminal electrode 22e is not formed in the pattern that bypasses the entire portion of the channel region formed between source electrode 5 and drain electrode 6 as illustrated in Fig. 20, the variation in the capacitance value due to the signal between the first terminal electrode and the second terminal electrode can be prevented even in the pattern overlapping a part of the channel region.

As described above, in variable capacitive element 100e, terminal electrode 22e has the first region overlapping source electrode 5 in planar view and the second region overlapping drain electrode 6 in planar view, and the first region and the second region are electrically connected while bypassing at least one part of the channel region formed between source electrode 5 and drain electrode 6. At this point, terminal electrode 22e bypasses at least one part of the channel region formed between source electrode 5 and drain electrode 6 means that the terminal electrode has a portion that does not overlap at least one part of the channel region in planar view.

In variable capacitive element 100e, the configuration in which element portion 20e is provided on switch portion 10 as illustrated in Fig. 19 has been described. However, element portion 20e may be provided below switch portion 10. In addition, a multi-valued variable electronic element may be similarly configured by forming a plurality of variable capacitive elements 100e in a matrix shape. Furthermore, the configuration of variable capacitive element 100e may be applied to a variable electronic element such as an inductor or a resistor other than the capacitor.

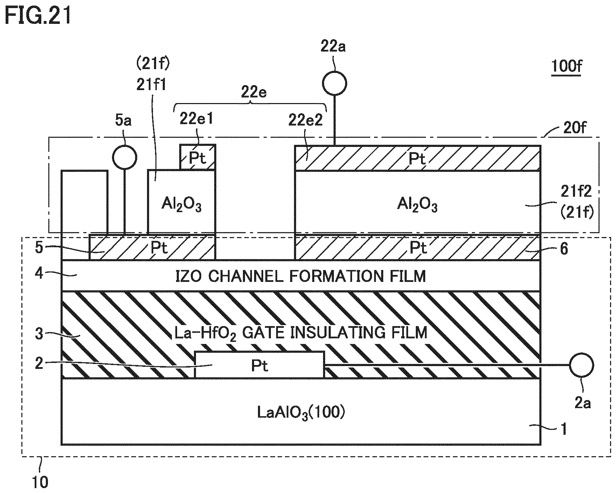

In a variable capacitive element 100f according to the eighth embodiment, it has been described that the terminal electrode 22e is formed in the pattern avoiding the channel region formed between source electrode 5 and drain electrode 6. However, the dielectric may also be formed in the pattern avoiding the channel region in accordance with the pattern of the terminal electrode. Specifically, Fig. 21 is a sectional view illustrating a configuration of a variable capacitive element 100f according to a modification of the eighth embodiment. In variable capacitive element 100f of Fig. 21, the same components as those of variable capacitive element 100e in Figs. 19 and 20 are denoted by the same reference numerals, and the detailed description thereof will not be repeated.

A variable capacitive element 100f illustrated in Fig. 21 includes a switch portion 10 configuring the field effect transistor formed on semiconductor substrate 1, and an element portion 20f electrically connected to switch portion 10 and configuring the passive element. Element portion 20f is provided above switch portion 10.

Element portion 20f includes the $Al_2O_3$ film of a dielectric 21f and terminal electrode 22e (second terminal electrode) of platinum (Pt) formed to overlap dielectric 21f. As illustrated in Fig. 20, terminal electrode 22e is formed in a pattern avoiding the channel region formed between source electrode 5 and drain electrode 6. Dielectric 21f is formed in the pattern avoiding the channel region formed between source electrode 5 and drain electrode 6 in accordance with the pattern of terminal electrode 22e. Therefore, in the sectional view of Fig. 21, a dielectric 21f1 and terminal electrode 22e1 formed on the upper portion of source electrode 5 are illustrated separately from a dielectric 21f2 and terminal electrode 22e2 formed on the upper portion of drain electrode 6. When terminal electrode 22e bypasses at least one part of the channel region formed between source electrode 5 and drain electrode 6, dielectric 21f is formed so as to avoid at least one part of the channel region formed between source electrode 5 and drain electrode 6 in accordance with the pattern of terminal electrode 22e.

(Modification)

In variable capacitive elements 100,100a to 100d and the variable inductance element 200 described in the above-described embodiments, the Q value (Q = 1 / ωCR) of switch portion 10 is required to be improved in order to improve the variable speed, namely, the switching speed. Here, ω is each frequency. That is, the switching speed can be improved by reducing parasitic resistance R and capacitor C (parasitic capacitance).

Parasitic resistance R corresponds to the series resistance of channel formation film 4 and is given by R = ρ (L / (Wt)). Here, ρ is a material-specific resistivity of channel formation film 4, L is a channel length, W is a channel width, and t is a film thickness of channel formation film 4.

As described above, parasitic resistance R depends on the value of channel length L / channel width W. Consequently, the Q factor can be improved by increasing channel width W with respect to channel length L. In switch portion 10, source electrode 5 and drain electrode 6 are provided on channel formation film 4 as illustrated in Fig. 2, so that channel length L and channel width W can be easily changed by the device design.

On the other hand, capacitor C (parasitic capacitance) corresponds to the capacitance of gate insulating film 3 of switch portion 10, is proportional to the relative dielectric constant of gate insulating film 3, and is inversely proportional to the film thickness. Consequently, switch portion 10 has the structure separated from element portion 20, so that capacitor C (parasitic capacitance) can be individually adjusted.

For example, in variable capacitive element 100 of the first embodiment, when channel length L is 10 μm, when channel width W is 100 μm, when parasitic resistance R is 1 kΩ, and when capacitor C (parasitic capacitance) is 10 pF, the Q value is 0.02 at 1 MHz. Here, when channel length L is miniaturized to 1 μm, when channel width W is 1000 μm, when the film thickness of gate insulating film 3 is 10 times (7000 μm), and when the relative permittivity of gate insulating film 3 is 1/5 (about 40 ~ 50), the Q value is 100. Consequently, the switching speed of switch portion 10 can be improved to 5000 times.

In the above-described embodiment, it has been described that the IZO film is used for channel formation film 4, but this is an example, and another film such as an ITO film may be used. In addition, in the above-described embodiment, it has been described that the $La-HfO_2$ film is used for gate insulating film 3, but this is an example, and another film such as a $Ce-HfO_2$ film may be used.

In the variable electronic element described in the above-described embodiment, for example, in variable capacitive element 100, channel formation film 4 is formed below source electrode 5 and drain electrode 6 as illustrated in Fig. 1 (top contact structure). The top contact structure is a structure in which the upper side of channel formation film 4 is in contact with source electrode 5 and drain electrode 6 when viewed from the side of gate electrode 2. However, the present invention is not limited thereto, and in the variable electronic element, for example, channel formation film 4 may be formed on the upper side of source electrode 5 and drain electrode 6 in variable capacitive element 100 (bottom contact structure). The bottom contact structure is a structure that is in contact with source electrode 5 and drain electrode 6 on the lower side of channel formation film 4 when viewed from the side of gate electrode 2.

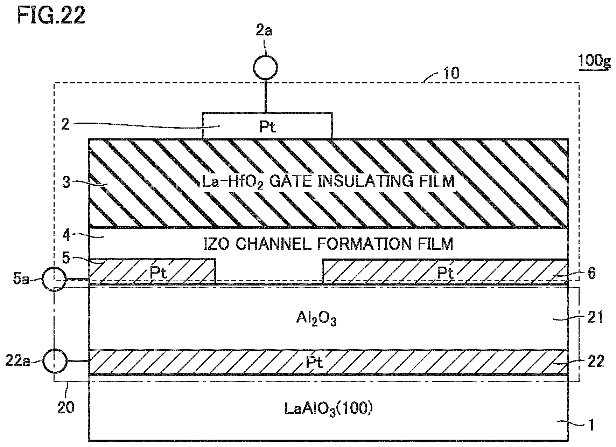

In the variable electronic element described in the above-described embodiment, for example, as illustrated in Fig. 1, the bottom gate structure in which gate electrode 2 is formed on semiconductor substrate 1, gate insulating film 3 and channel formation film 4 are sequentially formed so as to overlap gate electrode 2, and source electrode 5 and drain electrode 6 are respectively formed on gate insulating film 3 and channel formation film 4 is adopted in variable capacitive element 100. However, the present invention is not limited thereto, but the variable electronic element may adopt a top gate structure. Fig. 22 is a sectional view illustrating a configuration of a variable capacitive element 100g according to a modification. In variable capacitive element 100g, as illustrated in Fig. 22, element portion 20 is provided below switch portion 10. Switch portion 10 adopts the top gate structure in which source electrode 5 and drain electrode 6 are formed on dielectric 21, channel formation film 4 and gate insulating film 3 are sequentially formed so as to overlap source electrode 5 and drain electrode 6, and gate electrode 2 is formed on gate insulating film 3. In variable capacitive element 100g of Fig. 22, the same components as those of the variable capacitive element 100 in Fig. 1 are denoted by the same reference numerals, and the detailed description thereof will not be repeated.

In variable capacitive element 100g having the top gate structure, the top contact structure in which source electrode 5 and drain electrode 6 are in contact with each other on the upper side of channel formation film 4 when viewed from the side of gate electrode 2 is adopted as illustrated in Fig. 22. However, the present invention is not limited thereto, and the bottom contact structure in contact with source electrode 5 and drain electrode 6 on the lower side of channel formation film 4 when viewed from the side of gate electrode 2 may be adopted even in variable capacitive element 100g having the top gate structure.

Materials that can be adopted for gate insulating film 3 and dielectric 21 will be collectively listed below. Of course, the material is not limited to the following description.

- Amorphous or polycrystalline metal oxide such as $SiO_2$, $Al_2O_3$, $HfO_2$, $ZrO_2$, $La_2O_3$, or $Ta_2O_5$
- Nitride film such as SiN, $Si_3N_4$, or SiON
- Ferroelectric films obtained by doping the ferroelectric $HfO_2$ and $HfO_2$ with at least one trivalent, tetravalent, or pentavalent metal atom such as Si, Ce, Y, Zr, Bi, Ni, Ta, or La, a ferroelectric material using $PbTiO_3$ as a mother crystal, a ferroelectric material using $BaTiO_3$ as a mother crystal, a ferroelectric material having a Bi layered structure, a metal oxide having a perovskite type crystal, a metal oxide having a pyrochlore type crystal, an organic ferroelectric material, and other resin materials (polyimide, acryl, epoxy, polypropylene, polyester, polyethylene terephthalate, polyethylene naphthalate, polyphenylene sulfide, polylactic acid, and the like)

Materials that can be adopted for channel formation film 4 are collectively listed below. Of course, the material is not limited to the following description.

- In-O, In-Sn-O, In-Zn-O, In-Sn-Zn-O, In-Ga-Zn-O, In-Ga-O, Ga-O, Zn-O, Al-Zn-O, Sn-O, Ti-O-based n-type oxide semiconductor
- Cu-O, Sn-O, Zn-O-based p-type oxide semiconductor
- Cu-Sn-I-based amorphous p-type oxide semiconductor
- Si semiconductor such as n-type Si, p-type Si, or SiC
- Nitride semiconductors such as GaN
- Graphene and transition metal chalcogenide-based two-dimensional conductive material
- Perovskite-type conductive material such as $LaNiO_3$, $BaSnO_3$, and $SrTiO_3$

In variable capacitive elements 100 to 100g described in the above-described embodiments, when a ferroelectric film such as a La-HfO$_2$ film is used for gate insulating film 3, the configuration of the ferroelectric gate transistor is included. For this reason, variable capacitive elements 100 to 100g have memory characteristics derived from the configuration of the ferroelectric gate transistor. Specifically, in variable capacitive element 100 of Fig. 1, a capacitance value $C_{on}$ generated when an on voltage (for example, +10 V) is applied to gate electrode 2 to configure the capacitor between terminal electrode 22 and drain electrode 6 can be held only by applying a holding voltage of 0 (zero) V or a small constant value (for example, -1.0 V) to gate electrode 2. Similarly, in variable capacitive element 100, a capacitance value $C_{off}$ generated when an off voltage (for example, -10 V) is applied to gate electrode 2 and the capacitor is not configured between terminal electrode 22 and drain electrode 6 can be held only by applying the holding voltage of 0 (zero) V or the small constant value (For example, -1.0 V) to gate electrode 2.

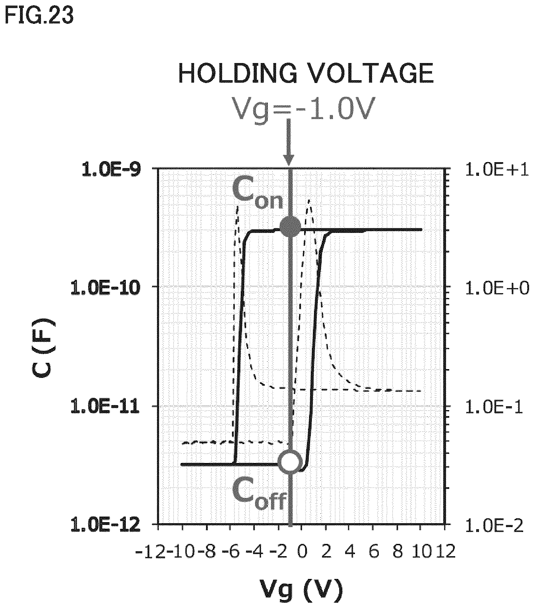

Fig. 23 is a view illustrating a relationship between the capacitance and the holding voltage of the variable capacitive element. In Fig. 23, the horizontal axis represents the gate voltage, and the vertical axis represents the capacitance. When the ferroelectric gate transistor is configured using the ferroelectric film such as the La-HfO$_2$ film for gate insulating film 3, as illustrated in Fig. 23, the change in capacitance value C generated between terminal electrode 22 and drain electrode 6 with respect to gate voltage Vg applied to gate electrode 2 becomes a hysteresis curve. In Fig. 23, it can be seen that capacitance value $C_{on}$ and capacitance value $C_{off}$ can be maintained by applying the holding voltage of -1.0 V to gate electrode 2.

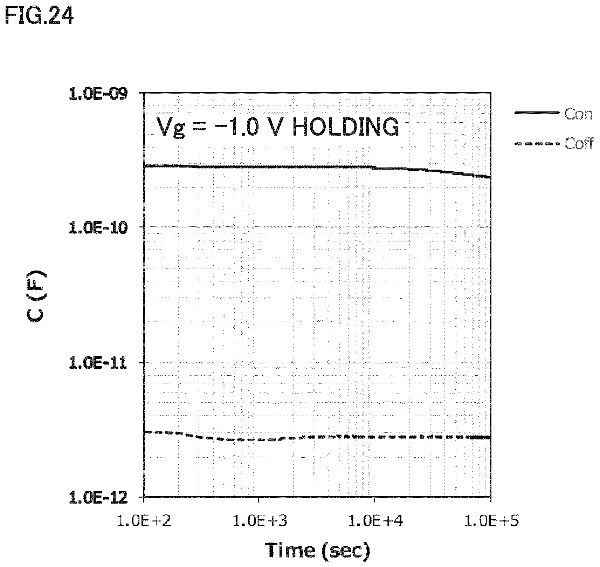

Fig. 24 is a diagram for explaining the relationship between the capacitance and the retention time of the variable capacitive element. In Fig. 24, the horizontal axis represents the time, and the vertical axis represents the capacitance. As illustrated in Fig. 24, capacitance value $C_{on}$ and capacitance value $C_{off}$ can be maintained without being changed for about $1.0 \times 10^5$ sec (27 hours) while the holding voltage of -1.0 V is applied to gate electrode 2. Consequently, when the configuration of the ferroelectric gate transistor is adopted in variable capacitive elements 100 to 100g, the high gate voltage to hold the capacitance is not required to be applied, so that power saving can be achieved and degradation of the element can be prevented.

It should be considered that the disclosed embodiment is an example in all respects and not restrictive. The scope of the present invention is defined by not the above description, but the claims, and it is intended that all modifications within the meaning and scope of the claims are included in the present invention.

REFERENCE SIGNS LIST

1: semiconductor substrate, 1a: silicon substrate, 2: gate electrode, 2a: control electrode terminal, 3: gate insulating film, 4: channel formation film, 5: source electrode, 5a, 22: terminal electrode, 6: drain electrode, 10: switch portion, 20: element portion, 21: dielectric, 22a: terminal, 23, 24: coil electrode, 25: nonmagnetic ceramic, 100, 100a to g: variable capacitive element, 200: variable inductance element, 300, 400, 500: circuit device

**Claims**

1. A variable electronic element comprising:

    a switch portion that configures a field effect transistor; and
    an element portion that is electrically connected to the switch portion to configure a passive element, wherein the switch portion includes:

        a source electrode;
        a drain electrode;
        a channel formation film formed to overlap at least a part of the source electrode and a part of the drain electrode;
        a gate insulating film formed to overlap the channel formation film; and
        a gate electrode formed to overlap the gate insulating film, and

    the element portion includes:

        a first terminal electrode electrically connected to the source electrode; and
        a second terminal electrode that configures a first passive element with the source electrode and configures a second passive element at least with the drain electrode.

2. The variable electronic element according to claim 1, wherein the switch portion is provided on an upper portion or a lower portion of the element portion.

3. The variable electronic element according to claim 1 or 2, wherein the passive element is any one of a capacitor, an inductor, and a resistor.

4. The variable electronic element according to any one of claims 1 to 3, wherein

    the passive element is a capacitor,
    the element portion further includes a dielectric provided to overlap the source electrode and the drain electrode,
    the dielectric between the source electrode and the second terminal electrode configures a first capacitor serving as the first passive element, and
    the dielectric between at least the drain electrode and the second terminal electrode configures a second capacitor serving as the second passive element.

5. The variable electronic element according to claim 4, wherein

    the gate electrode is formed on a semiconductor substrate,

the gate insulating film is formed on the gate electrode and the semiconductor substrate,
the channel formation film is formed on the gate insulating film,
the source electrode and the drain electrode are formed on the channel formation film,
the dielectric is formed on the source electrode and the drain electrode, and
the second terminal electrode is formed on the dielectric.

6. The variable electronic element according to any one of claims 1 to 3, wherein

the passive element is an inductor, and
the element portion includes:

a first inductor that is electrically connected between the source electrode and the second terminal electrode
to serve as the first passive element; and
a second inductor that is electrically connected between the drain electrode and the second terminal electrode to serve as the second passive element.

7. The variable electronic element according to any one of claims 1 to 6, wherein

a portion where the gate electrode and the channel formation film overlap each other in planar view is used in place of the drain electrode, and
the second passive element is configured between the portion and the second terminal electrode.

8. The variable electronic element according to any one of claims 1 to 6, wherein

the second terminal electrode includes a first region overlapping the source electrode in planar view and a second region overlapping the drain electrode in planar view, and
the first region and the second region are electrically connected while bypassing at least a part of a channel region formed between the source electrode and the drain electrode.

9. The variable electronic element according to claim 4 or 5, wherein

the second terminal electrode includes a first region overlapping the source electrode in planar view and a second region overlapping the drain electrode in planar view,
the first region and the second region are electrically connected while bypassing at least a part of a channel region formed between the source electrode and the drain electrode, and
the dielectric is formed to avoid at least a part of a channel region formed between the source electrode and the drain electrode in accordance with a pattern of the second terminal electrode.

10. A circuit device comprising:

a circuit wiring; and
the variable electronic element according to any one of claims 1 to 9 electrically connected to the circuit wiring.

## FIG.1

FIG.2

FIG.3

FIG.4

# FIG.5

(a)

| Pt | — 2 |
| LaAlO$_3$(100) | — 1 |

(b)

| La–HfO$_2$ GATE INSULATING FILM | — 3 |
| Pt | — 2 |
| LaAlO$_3$(100) | — 1 |

(c)

| IZO CHANNEL | — 4 |
| La–HfO$_2$ GATE INSULATING FILM | — 3 |
| Pt | — 2 |
| LaAlO$_3$(100) | — 1 |

(d)

5 — Pt        Pt — 6

| IZO CHANNEL | — 4 |
| La–HfO$_2$ GATE INSULATING FILM | — 3 |
| Pt | — 2 |
| LaAlO$_3$(100) | — 1 |

(e)

| Al$_2$O$_3$ | — 21 |

5 — Pt        Pt — 6

| IZO CHANNEL | — 4 |
| La–HfO$_2$ GATE INSULATING FILM | — 3 |
| Pt | — 2 |
| LaAlO$_3$(100) | — 1 |

(f)

| Pt | — 22 |
| Al$_2$O$_3$ | — 21 |

5 — Pt        Pt — 6

| IZO CHANNEL | — 4 |
| La–HfO$_2$ GATE INSULATING FILM | — 3 |
| Pt | — 2 |
| LaAlO$_3$(100) | — 1 |

FIG.6

FIG.7

(a)

GATE INSULATING FILM

(b)

GATE INSULATING FILM

Si

**FIG.8**

FIG.9

FIG.10

(a)

(b)

FIG.11

(a)

(b)

FIG.12

# FIG.13

(a)

PWM  ON  OFF

$V_{DS}$  $L_D$

(b)

PWM  ON  OFF

$V_{DS}$  $L_D$

FIG.14

FIG.15

FIG.16

RE-ELECTROMOTIVE
VOLTAGE V

Vth

S1 OFF

TIME t

R2

R1

FIG.17

FIG.18

FIG.19

FIG.20

FIG.21

FIG.22

FIG.23

HOLDING VOLTAGE
Vg=-1.0V

FIG.24

| | |
|---|---|
| **INTERNATIONAL SEARCH REPORT** | International application No. |
| | **PCT/JP2021/037331** |

**A.    CLASSIFICATION OF SUBJECT MATTER**

*H01L 27/04*(2006.01)i; *H01G 4/30*(2006.01)i; *H01G 4/33*(2006.01)i; *H01G 4/40*(2006.01)i; *H01L 21/822*(2006.01)i;
*H01L 21/8234*(2006.01)i; *H01L 27/06*(2006.01)i; *H03H 5/12*(2006.01)i
FI:    H01L27/04 C; H01G4/40 A; H03H5/12; H01G4/30 201Z; H01G4/33 102; H01L27/06 102A

According to International Patent Classification (IPC) or to both national classification and IPC

**B.    FIELDS SEARCHED**

Minimum documentation searched (classification system followed by classification symbols)

H01L27/04; H01G4/30; H01G4/33; H01G4/40; H01L21/822; H01L21/8234; H01L27/06; H03H5/12

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2018/173497 A1 (SONY SEMICONDUCTOR SOLUTIONS CORP) 27 September 2018 (2018-09-27) | 1-10 |
| A | CN 102570839 A (XI'AN GAODU ELECTRONIC TECHNOLOGY CO., LTD.) 11 July 2012 (2012-07-11) | 1-10 |
| A | US 2004/0140528 A1 (KIM, Cheon-Soo et al.) 22 July 2004 (2004-07-22) | 1-10 |
| A | JP 2010-272815 A (RENESAS ELECTRONICS CORP) 02 December 2010 (2010-12-02) | 1-10 |
| A | JP 2009-147204 A (TAIYO YUDEN CO LTD) 02 July 2009 (2009-07-02) | 1-10 |
| E, A | WO 2021/205695 A1 (MURATA MANUFACTURING CO) 14 October 2021 (2021-10-14) | 1-10 |

☐ Further documents are listed in the continuation of Box C.       ☑ See patent family annex.

| | | |
|---|---|---|
| * | Special categories of cited documents: | "T"    later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"    document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"    document member of the same patent family |

| Date of the actual completion of the international search | Date of mailing of the international search report |
|---|---|
| **19 November 2021** | **07 December 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
**Information on patent family members**

International application No.

**PCT/JP2021/037331**

| Patent document cited in search report | | | Publication date (day/month/year) | Patent family member(s) | | | Publication date (day/month/year) |
|---|---|---|---|---|---|---|---|
| WO | 2018/173497 | A1 | 27 September 2018 | US | 2020/0013772 | A1 | |
| | | | | CN | 110419163 | A | |
| CN | 102570839 | A | 11 July 2012 | (Family: none) | | | |
| US | 2004/0140528 | A1 | 22 July 2004 | KR | 10-2004-0042130 | A | |
| JP | 2010-272815 | A | 02 December 2010 | US | 2010/0295625 | A1 | |
| JP | 2009-147204 | A | 02 July 2009 | (Family: none) | | | |
| WO | 2021/205695 | A1 | 14 October 2021 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002373829 A

**Non-patent literature cited in the description**

- **TOKUMITSU EISUKE ; KIKUCHI KAZUYA.** Evaluation of Channel Modulation in In2O3/(Bi,La)4Ti3O12 Ferroelectric-Gate Thin Film Transistors by Capacitance-Voltage Measurements. *Ferroelectrics,* June 2012, vol. 429, 15-21

- **RYUICHI SHIMADA.** Smart Switch with Semiconductor Device (Hybrid Switching/Connecting device). *Journal of the Power Electronics Society of Japan,* March 2017, vol. 42, 53-57